# EUROPÄISCHE PATENTSCHRIFT

(11) **EP 4 268 552 B1**
(45) Veröffentlichungstag und Bekanntmachung des Hinweises auf die Patenterteilung: **20.11.2024**
(21) Anmeldenummer: 22706045.6
(22) Anmeldetag: 16.02.2022
(51) Int. Cl.: H05K 7/20

(54) **KÜHLVORRICHTUNG ZUR KÜHLUNG EINES HALBLEITERMODULS UND UMRICHTER MIT DER KÜHLVORRICHTUNG**
COOLING DEVICE FOR COOLING A SEMICONDUCTOR MODULE AND CONVERTER WITH THE COOLING DEVICE
DISPOSITIF DE REFROIDISSEMENT DESTINÉ AU REFROIDISSEMENT D'UN MODULE SEMI-CONDUCTEUR ET ONDULEUR POURVU DE DISPOSITIF DE REFROIDISSEMENT

(30) Priorität: 31.03.2021 EP 21166370
(43) Veröffentlichungstag der Anmeldung: 01.11.2023
(73) Patentinhaber: Siemens Aktiengesellschaft, 80333 München (DE)
(72) Erfinder: WEIS, Benno, 91334 Hemhofen (DE)
(74) Vertreter: Siemens Patent Attorneys
(86) Internationale Anmeldenummer: PCT/EP2022/053770
(87) Internationale Veröffentlichungsnummer: WO 2022/207179

(56) Entgegenhaltungen:
- CN-A- 108 966 482
- DE-U1- 202021 100 332
- GB-A- 2 502 148
- KR-A- 20110 041 014
- US-A- 4 027 206
- US-A1- 2018 310 396
- US-B2- 10 939 586

## Beschreibung

Die Erfindung betrifft eine Kühlvorrichtung mit einem Halbleitermodul zur Kühlung des Halbleitermoduls und einen Umrichter mit der Kühlvorrichtung.

In praktisch allen Anwendungsgebieten der Industrie und Energieerzeugung/Energieverteilung sind die Anforderungen an einen kompakteren Aufbau von elektrischen Geräten, in der Antriebstechnik an den kompakteren Aufbau von elektrischen Umrichtern, kaum zu ignorieren, wenn sich ein wirtschaftlicher und technischer Erfolg durch die Anbietung und den Einsatz dieser elektrischen Geräte einstellen soll.

So besteht beispielsweise für Umrichter bzgl. deren elektrischer Dimensionierung, deren spezialisierter Einsatzaufgaben oder auch deren örtlicher Einbaubegrenzungen der Bedarf an modularisierten und strukturierten Lösungen.

So können beispielsweise Umrichter mehrere Umrichtermodule und Umrichtersysteme mehrere Umrichter aufweisen, die sich in ihrer Funktionalität und elektrischer Dimensionierung gleichen können, aber auch Unterschiede aufweisen können. Standardisierte Kopplungsmechanismen, mittels beispielweise Rückwandbussen, sollen und können derartige Umrichter bzw. Umrichtersysteme technisch und räumlich sehr nah zusammenbringen.

Dies macht es jedoch notwendig, zumindest alle technisch relevanten Bauelemente des Umrichters möglichst noch kompakter an einem bzw. in einem Umrichter anzuordnen.

Ein Beispiel dafür zeigt die Siemens-Umrichterreihe SINAMICS S120 der Bauform Booksize. Wie der Name nahelegt, weist der Umrichter oder auch seine Umrichtermodule bzgl. des geometrischen bzw. anschaulichen Aufbaus eine Buchform auf. Die Höhe und die Tiefe der Bauform dieser Umrichterreihe sind aktuell im Wesentlichen fest vorgegeben, die Breite kann jedoch variieren. Demnach bietet die Breite Potential, den Bauraum weiter zu minimieren.

Baugruppen in Umrichtern, welche oftmals noch einen anteilig großen Bauraum erfordert, sind Kühlkörper bzw. Kühlvorrichtungen zur Entwärmung von elektrischen bzw. elektronischen Bauelementen in Kombination mit diesen Bauelementen.

Die minimale Breite der genannten Umrichterreihe wird hauptsächlich noch durch die Auslegung der Kühlvorrichtung mit dem Kühlkörper und das zur betrieblichen Entwärmung mit dem Kühlkörper verbundene Halbleitermodul bestimmt. Als Halbleitermodul wird in diesem Zusammenhang sowohl ein Halbleitermodul mit einem einzelnen Halbleiter aber auch ein Halbleitermodul in Form einer Brückenschaltung mit mehreren Halbleitern - wie beispielsweise in einer Sechspuls-Brückenschaltung (B6-Brücke) - verstanden. Typische Halbleiter sind als Leistungshalbleiter ausgebildete IGBTs (Insulated-Gate Bipolar Transistor) oder MOSFETs (Metal Oxide Semiconductor Field-Effect Transistor).

CN 108 966 482 A offenbart ein Halbleitermodul, das auf einer Leiterplatte platziert und von einem Kühlkörper abgedeckt wird, der Kühlrippen aufweist, die das Halbleitermodul umgeben, so dass Luft um das Modul strömen kann und der Raum zwischen der Leiterplatte und dem Kühlkörper effektiv gekühlt wird.

Die Dokumente GB 2 502 148 A, KR 2011 0041014 A und US 4 027 206 A offenbaren ähnliche Anordnungen.

Die Dokumente US 2018/310396 A1 und US 10 939 586 B2 offenbaren einen Kühlkörper mit Kühlrippen und einer Tasche auf der anderen Seite der Basis des Kühlkörpers, die sich bis zur gleichen Höhe wie die Kühlrippen erstreckt.

DE 20 2021 100332 U1 offenbart eine Abdeckung, die die Kanäle zwischen den Kühlrippen eines Kühlkörpers umschließt.

Derzeit bekannte Aufbautechnologien existierender Kühlvorrichtung erfordern einen aus Sicht der Hersteller wie auch der Anwender immer noch zu hohen Platzbedarf, um beispielsweise neue technische Einsatzgebiete mittels kleinerer, dezentral angeordneter Umrichter zu erschließen oder Umrichter bzw. Umrichtermodule feingranularer bzgl. ihrer Leistungsdaten und ihrer Funktionalität einzusetzen.

Der Erfindung liegt die Aufgabe zugrunde, eine Kühlvorrichtung zur Kühlung eines Halbeitermoduls und einen Umrichter mit der Kühlvorrichtung vorzuschlagen, welche gegenüber dem Stand der Technik einen geringeren Platzbedarf benötigen.

Die Aufgabe wird durch eine Kühlvorrichtung mit den in Anspruch 1 angegebenen Merkmalen und durch einen Umrichter mit den in Anspruch 14 angegebenen Merkmalen gelöst.

Für die Lösung der Aufgabe wird eine Kühlvorrichtung mit einem Halbleitermodul und einem Kühlkörper zur Kühlung des Halbleitermoduls vorgeschlagen, wobei das Halbleitermodul eine erste und zweite Deckfläche und mehrere Seitenflächen aufweist, wobei die erste von der zweiten Deckfläche abgewandt ist, wobei zwischen den Deckflächen ein Modulraum des Halbleitermoduls ausgebildet ist, welcher von den Seitenflächen umschlossen ist, wobei der Kühlkörper einen Grundkörper aufweist, wobei an einer ersten Fläche des Grundkörpers von dem Grundkörper abstehende Kühlelemente ausgebildet sind, wobei das Halbleitermodul an der ersten Deckfläche mit der ersten Fläche des Grundkörpers verbunden ist und das Halbleitermodul zwischen zumindest einigen der Kühlelemente eingebettet ist.

Eine Ausrichtung und Anordnung der Kühlelemente erfolgt der art, dass das zu entwärmende Halbleitermodul mit möglichst einer großen Fläche, insbesondere seiner Seitenflächen, in der Strömungsrichtung angeordnet ist und so von dem Kühlmedium erfindungsgemäß umströmt und entwärmt werden kann.

Zumindest eine erste und eine zweite Seitenfläche der Seitenflächen des Halbleitermoduls bilden eine gemeinsame Seitenkante aus und die gemeinsame Seitenkante der ersten und zweiten Seitenfläche ist der Strömungsrichtung zugewandt.

An der Seitenkante kann sich das in Strömungsrichtung strömende Kühlmedium brechen, so dass es sich teilt und hier beispielhaft beide Seitenflächen des Halbleitermoduls in erfindungsgemäße Weise umströmen und entwärmen kann.

Durch die Einbettung des Halbleitermoduls zwischen den Kühlelementen verringert sich das Aufbauvolumen und damit der Platzbedarf des erfindungsgemäßen Aufbaus aus Kühlkörper, Kühlelementen und Halbleitermodul in vorteilhafter Weise gegenüber einem bekannten Aufbau, bei dem die Kühlelemente nicht auf der als Montagefläche des Halbleitermoduls ausgewiesenen ersten Fläche des Grundkörpers ausgebildet und somit nicht gemeinsam mit dem Halbleitermodul mittels dieser speziellen Aufbautopologie angeordnet sind.

Unter dem Begriff Einbettung wird hier im räumlichen Sinne auch ein Umfassen, ein Umschließen, ein Umgeben oder ein Begrenzen des Halbleitermoduls insbesondere an seinen Seitenflächen durch die Kühlelemente verstanden. Ein so entstehender Einbettungsraum für das Halbleitermodul ist zumindest auch durch die erste Fläche des Grundkörpers des Kühlkörpers begrenzt.

In dem gebildeten Modulraum des Halbleitermoduls kann ein einzelner Halbleiter oder mehrere Halbleiter, beispielsweise in Form einer B6-Brückenschaltung, angeordnet sein.

Die Anzahl der Seitenflächen, welche den Modulraum mit ausbilden, ist nicht begrenzt, wobei aber mindestens drei Seitenflächen vorgesehen sind.

Vorteilhafte Ausgestaltungsformen der Kondensatorvorrichtung sind in den abhängigen Ansprüchen angegeben.

Bei einer ersten vorteilhaften Ausgestaltungsform der Kühlvorrichtung sind die Kühlelemente als Kühlrippen oder Pin Fins oder einer Kombination aus Kühlrippen und Pin Fins ausgebildet.

Der Begriff Pin Fin ist ein zwischenzeitlich im Zusammenhang mit Kühlkörpern technisch etablierter Begriff. Er kennzeichnet stiftartige Ausbuchtungen an Kühlkörpern, welche gegenüber herkömmlichen Kühlrippen in der Regel, als einzelner Pin Fin, kleiner und feingranularer auf einer Oberfläche eines Kühlkörpers verteilbar sind.

Mittels herkömmlicher Kühlrippen kann ein Konvektionsstrom im Allgemeinen vorteilhaft kanalartig in eine Richtung über den Kühlkörper geleitet werden, wobei Pin Fins mittels ihrer feingranularen Anordnungsmöglichkeit einen Konvektionsstrom an spezifischen Stellen auch vorteilhaft ausdünnen oder, unter Erzeugung örtlicher Wirbel, verstärken können.

Je nach Anforderung an beispielsweise die Bauform des zu entwärmenden Halbleitermoduls können Kühlrippen, Pin Fins oder eine Kombination aus beiden Kühlelementen effektiver sein.

Bei einer weiteren vorteilhaften Ausgestaltungsform der Kühlvorrichtung ist das Halbleitermodul an seiner zweiten Deckfläche mit einem Bauteilträgerelement, insbesondere einer Leiterplatte, verbunden.

Eine elektrische Anbindung des Halbleitermoduls erfolgt meist über das Bauteilträgerelement, bevorzugt die Leiterplatte.

Die vorteilhafte Anordnung des Halbleitermoduls zwischen der ersten Fläche des Grundkörpers und dem Bauteilträgerelement reduziert den zur Anbindung des Halbleitermoduls an den Kühlkörper erforderlichen Platzbedarf weiter in vorteilhafter Weise.

Als Bauteilträgerelement kann auch eine Stromschiene oder ein anderer elektrische Leiter eingesetzt werden, an der das dann Halbleitermodul befestigt ist.

Bei einer weiteren vorteilhaften Ausgestaltungsform der Kühlvorrichtung weist die Kühlvorrichtung eine Kühlelementabdeckung auf, wobei die Kühlelemente jeweils einen von dem Grundkörper abgewandten Kühlelementabschluss ausbilden und zumindest einige der Kühlelemente an deren Kühlelementabschlusses mit der Kühlelementabdeckung verbunden sind

Mittels der Kühlelementabdeckung können gerichtete Kühlkanäle besser gegen die Umgebung der Kühlvorrichtung abgeschottet werden, wobei eine Konvektion zielgerichteter zumindest an den Seitenflächen des Halbleitermoduls vorbeiführbar und somit das Halbleitermodul vorteilhaft entwärmbar ist.

Bei einer weiteren vorteilhaften Ausgestaltungsform der Kühlvorrichtung ist die Kühlelementabdeckung aus einem gleichen metallischen Material ausgebildet, wie der Grundkörper des Kühlkörper und/oder die Kühlelemente.

Die Kühlelementabdeckung weist damit ebenfalls die aufgrund der metallischen Ausprägung üblicherweise sehr guten thermischen Kühleigenschaften des Grundkörpers und/oder der Kühlelemente auf, so dass eine verbesserte Abführung der im Betrieb des Halbleitermoduls erzeugten Verlustwärme an die Umgebung der Kühlvorrichtung vorteilhaft durchführbar ist.

Bei einer weiteren vorteilhaften Ausgestaltungsform der Kühlvorrichtung ist der Kühlkörper monolithisch aus dem Grundkörper, den Kühlelementen und der Kühlelementabdeckung ausgebildet.

Der derart vorgestellte monolithische Aufbau ermöglicht eine kompakt und industriell kostengünstig herstellbare Kühlvorrichtung.

Da das Halbleitermodul zwischen den Kühlelementen eingebettet und mit der ersten Fläche der Grundplatte verbunden ist, kann bei der Herstellung der Kühlvorrichtung eine Aussparung in der Abdeckplatte zur Einbringung des Halbleitermoduls vorgesehen sein.

Bei einer weiteren vorteilhaften Ausgestaltungsform der Kühlvorrichtung ist die Kühlelementabdeckung als Bauteilträgerelement, insbesondere als Leiterplatte, ausgebildet.

Es ist eine Grundfunktionalität des Bauteilträgerelements / speziell der Leiterplatte, elektronischen und elektrotechnischen Bauelementen, wie dem des Halbleitermoduls, eine elektrische und mechanische Anbindung innerhalb eines elektrischen Gerätes, wie dem des Umrichters, zu geben. Demnach ist das Bauteilträgerelement / die Leiterplatte im Allgemeinen systemimmanenter Bestandteil von Umrichter. Die Kombination mit einer weiteren Funktion, der der Abdeckung der Kühlelemente, verringert vorteilhaft den Platzbedarf für die Kühlvorrichtung und kann helfen, die Abmaße und somit das Bauraumvolumen von Umrichtern vorteilhaft zu reduzieren.

Die Verwendung des Bauteilträgerelements / der Leiterplatte als Kühlelementabdeckung kann es erforderlich machen, dass eine elektrische Isolation des Bauteilträgerelements / der Leiterplatte gegenüber den Kühlelementen erfolgen muss.

Bei einer weiteren vorteilhaften Ausgestaltungsform der Kühlvorrichtung können die Kühlelemente und die Seitenflächen des Halbleitermoduls in einer Strömungsrichtung entlang des Grundkörpers mittels eines Kühlmediums umströmt werden.

Bei einer weiteren vorteilhaften Ausgestaltungsform der Kühlvorrichtung ist das Kühlmedium flüssig, insbesondere Wasser, oder gasförmig, insbesondere Luft.

Bei einer weiteren vorteilhaften Ausgestaltungsform der Kühlvorrichtung weist ein Kantenwinkel an der gemeinsamen Seitenkante zwischen der ersten und zweiten Seitenfläche einen Wert in einem Winkelbereich von 30° bis 60°, insbesondere von 45°, auf.

Es zeigt sich, dass der Kantenwinkel im Bereich von 30° bis 60° das Umströmen der Seitenflächen besonders effektiv macht, da es einerseits nicht zum Stau des Kühlmediums an den Seitenflächen kommt, andererseits das Kühlmedium nicht zu schnell an den Seitenflächen vorbeiströmt, ohne die Verlustwärme ausreichend aufnehmen und vom Halbleitermodul wegtransportieren zu können. Ein bevorzugter Wert für den Kantenwinkel sind 45°, was bei einem vierseitigen, rechteckigen Halbleitermodul baulich vorgegeben ist.

Bei einer weiteren vorteilhaften Ausgestaltungsform der Kühlvorrichtung wird eine maximale Kühlelementlänge der an der ersten Fläche des Grundkörpers ausgebildeten Kühlelemente, beginnend von der ersten Fläche des Grundkörpers bis zum Kühlelementabschluss des jeweiligen Kühlelements, durch einen Deckflächenabstand zwischen der ersten Deckfläche und der zweiten Deckfläche des Halbleitermoduls begrenzt.

Eines der bestimmenden Bauelemente für eine Gesamtbreite der Kühlvorrichtung ist das Halbleitermodul. Da es ein meist am Markt in seinen spezifischen Abmaßen erhältliches und damit vorgegebenes Bauelement ist, müssen sich insbesondere die Kühlelemente an den vorgegebenen Abmaßen des Halbleitermoduls orientieren.

Die hier benannten Deckflächen stellen, neben den Seitenflächen, die äußeren Abmaße des Halbleitermoduls dar, wobei elektrische Anschlüsse für die Ankontaktierung des Halbleitermoduls oder auch mechanische Befestigungsmittel aus dieser Betrachtung herausgenommen werden können.

Bei einer weiteren vorteilhaften Ausgestaltungsform der Kühlvorrichtung ist eine von der ersten Fläche des Grundkörpers abgewandte zweite Fläche des Grundkörpers frei von Kühlelementen.

Auf eine Ausbildung von Kühlelementen an der zweiten Fläche des Grundkörpers des Kühlkörpers wird vorteilhaft verzichtet, da so die Reduzierung der Baugröße und damit des Bauvolumens der Kühlvorrichtung besonders wirksam ist.

Für die Lösung der Aufgabe wird weiterhin ein Umrichter mit der erfindungsgemäßen Kühlvorrichtung und einem Umrichtergehäuse vorgeschlagen, wobei die Kühlvorrichtung in das Umrichtergehäuse integriert ist.

Der Einsatz der erfindungsgemäßen Kühlvorrichtung im Umrichter, mit einer Integration in das Umrichtergehäuse, reduziert maßgeblich insbesondere die Bauraumbreite des Umrichtergehäuses und damit des Umrichters.

Bei einer vorteilhaften Ausgestaltungsform des Umrichters ist eine erzwungene Konvektion des Kühlmediums durch einen Konvektionserzeuger erzeugbar.

Die erzwungene Konvektion forciert die Entwärmung des Halbleitermoduls, indem das Kühlmedium gezielter, schneller und in größerer Volumenzahl zu dem zu entwärmenden Halbleitermodul transportiert werden kann und, unter Aufnahme der im Betrieb entstehenden Verlustwärme des Halbleitermoduls, von diesem abtransportiert werden kann.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Darstellung als Schnitt durch eine bekannte Kühlvorrichtung, integriert in ein Umrichtergehäuse eines Umrichters,
- FIG 2: eine erste schematische Darstellung als Schnitt durch eine erfindungsgemäße Kühlvorrichtung, welche in ein Umrichtergehäuse eines erfindungsgemäßen Umrichters integriert ist,
- FIG 3: eine zweite schematische Darstellung als Schnitt durch die in das Umrichtergehäuse des erfindungsgemäßen Umrichters integrierte erfindungsgemäße Kühlvorrichtung nach FIG 2 und
- FIG 4: eine schematische Detaildarstellung der erfindungsgemäßen Kühlvorrichtung, integriert in das Umrichtergehäuse des erfindungsgemäßen Umrichters nach FIG 2 und FIG 3.

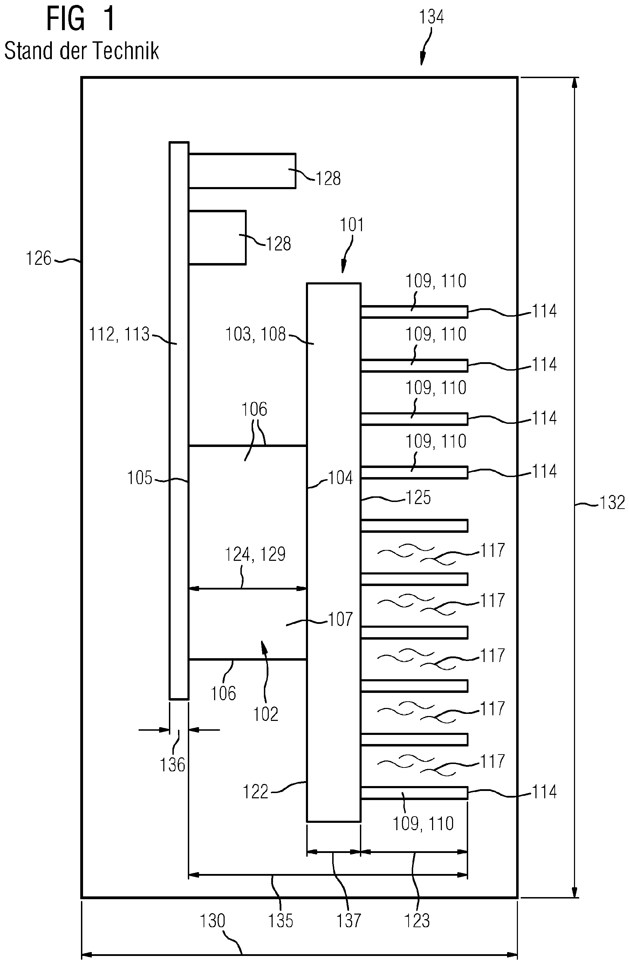

Die FIG 1 zeigt eine schematische Schnittdarstellung einer bekannten Kühlvorrichtung 101, welche in ein Umrichtergehäuse 126 eines Umrichters 134 integriert ist.

An einer ersten Fläche 122 eines Grundkörpers 108 eines Kühlkörpers 103 ist ein Halbleitermodul 102 über seine erste Deckfläche 104 mit dem Grundkörper 108 verbunden. Das Halbleitermodul 102 ist darüber hinaus über seine zweite Deckfläche 105 mit einem Bauteilträgerelement 112, hier einer Leiterplatte 113, verbunden.

Das Halbleitermodul 102 bildet einen Modulraum 107 aus, welcher durch die erste und zweite Deckfläche 104,105 und die Seitenflächen 106 bestimmt ist.

Das Bauteilträgerelement 112 / die Leiterplatte 113 weist weitere elektronische Bauelemente 128 auf, welche abseits der Kühlvorrichtung 101 angeordnet, aber mit dem Bauteilträgerelement 112 / der Leiterplatte 113 in das Umrichtergehäuse 126 des Umrichters 134 integriert sind.

Auf einer zweiten Fläche 125 des Grundkörpers 108 des Kühlkörpers 103, welche von der ersten Fläche 104 des Grundkörpers 108 abgewandt ist, sind Kühlelemente 109 in Form von Kühlrippen 110 ausgebildet, welche von dem Grundkörper 108 hier orthogonal abstehen. Die Kühlelemente 109 sowie die zweite Fläche 125 der Grundplatte 108 des Kühlkörpers 103 sind von einem Kühlmedium 117 umströmt.

Die Darstellung des Umrichtergehäuses 126 des Umrichters 134 zeigt eine Sicht auf das Umrichtergehäuse 126, welche eine Gehäusebreite 130 und eine Gehäusehöhe 132 des Umrichtergehäuses 126 erkennen lässt.

Die Gehäusebreite 130 des Umrichtergehäuses 126 des Umrichters 124 wird, wie FIG 1 auch augenscheinlich zeigt, wesentlich durch eine Kühlvorrichtungsbreite 135 der Kühlvorrichtung 101 bestimmt.

Diese Kühlvorrichtungsbreite 135 summiert eine Modulhöhe 129 des Halbleitermoduls 102, eine zweiten Dicke 137 des Grundkörpers 108 des Kühlkörpers 103 und eine maximale Kühlelementlänge 123 der Kühlelemente 109, hier der Kühlrippen 110.

Die Modulhöhe 129 bestimmt sich dabei durch den Deckflächenabstand 124 der ersten Deckfläche 104 von der zweiten Deckfläche 105 und die maximale Kühlelementlänge 123 bestimmt sich durch einen Abstand der zweiten Fläche 125 des Grundkörpers 108 von einem dem jeweiligen Kühlelement 109 zugeordneten Kühlelementabschluss 114, welcher jeweils von der zweiten Fläche 125 des Grundkörpers 108 abgewandt ist.

Zu der Kühlvorrichtungsbreite 135 kann noch die erste Dicke 136 des Bauteilträgerelements 112, hier der Leiterplatte 113 hinzugezählt werden, um einen Vergleich mit der Gehäusebreite 130 des Umrichtergehäuses 126 herstellen zu können.

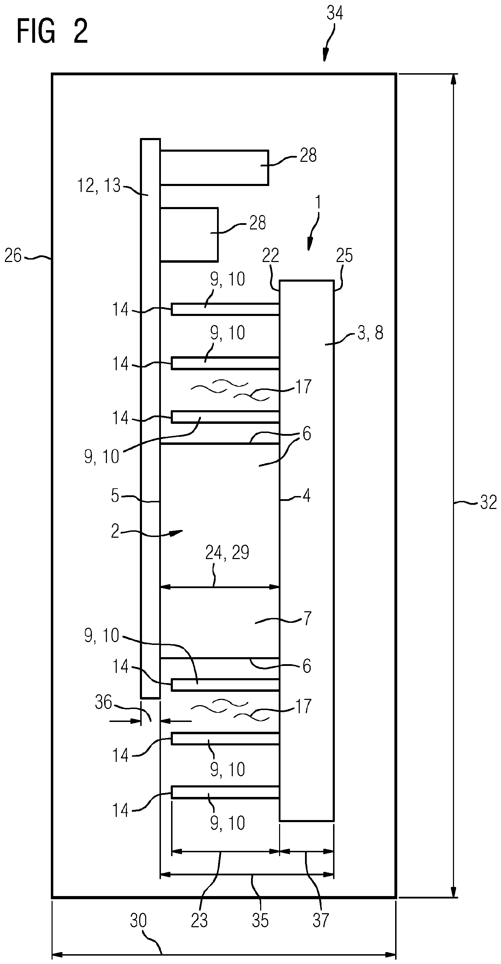

Mit FIG 2 wird eine erste schematische Schnittdarstellung einer erfindungsgemäßen Kühlvorrichtung 1 aufgezeigt, welche in ein Umrichtergehäuse 26 eines erfindungsgemäßen Umrichters 34 integriert ist.

An einer ersten Fläche 22 eines Grundkörpers 8 eines Kühlkörpers 3 ist ein Halbleitermodul 2 über seine erste Deckfläche 4 mit dem Grundkörper 8 verbunden. Das Halbleitermodul 2 ist darüber hinaus über seine zweite Deckfläche 5 mit einem Bauteilträgerelement 12, hier einer Leiterplatte 13, verbunden.

Das Halbleitermodul 2 bildet einen Modulraum 7 aus, welcher durch die erste und zweite Deckfläche 4,5 und die Seitenflächen 6 bestimmt ist.

Das Bauteilträgerelement 12 / die Leiterplatte 13 weist weitere elektronische Bauelemente 28 auf, welche abseits der Kühlvorrichtung 1 angeordnet, aber mit dem Bauteilträgerelement 12 / der Leiterplatte 13 in das Umrichtergehäuse 6 des Umrichters 4 integriert sind.

Ebenfalls an der ersten Fläche 22 des Grundkörpers 8 des Kühlkörpers 3 sind Kühlelemente 9 in Form von Kühlrippen 10 ausgebildet, welche von dem Grundkörper 8 hier orthogonal abstehen, wodurch das Halbleitermodul 2 von den Kühlelementen 9 eingebettet wird.

Sowohl das Halbleitermodul 2 wie auch die Kühlelemente 9 und die erste Fläche 22 des Grundkörpers 8 des Kühlkörpers 3 sind von einem Kühlmedium 17 umströmt.

Auf einer zweiten Fläche 25 des Grundkörpers 8 des Kühlkörpers 3, welche von der ersten Fläche 22 des Grundkörpers 8 abgewandt ist, sind keine Kühlelemente ausgebildet oder anderweitig Bauelemente angebracht.

Die Darstellung des Umrichtergehäuses 26 des Umrichters 34 zeigt eine Sicht auf das Umrichtergehäuse 26, welche eine Gehäusebreite 30 und eine Gehäusehöhe 32 des Umrichtergehäuses 26 erkennen lässt.

Die Gehäusebreite 30 des Umrichtergehäuses 26 des Umrichters 24 wird, wie FIG 2 auch augenscheinlich zeigt, wesentlich durch eine Kühlvorrichtungsbreite 35 der Kühlvorrichtung 1 bestimmt.

Diese Kühlvorrichtungsbreite 35 summiert eine Modulhöhe 29 des Halbleitermoduls 2 und eine zweiten Dicke 37 des Grundkörpers 8 des Kühlkörpers 3. Die Kühlelemente 9 sind bzgl. ihrer maximalen Kühlelementlänge 23 hier kleiner als die Modulhöhe 29 des Halbleitermoduls 2. Die Kühlelementlänge 23 geht somit nicht über die Modulhöhe 29 des Halbleitermoduls 2 hinaus und beeinflusst demnach auch nicht die ermittelte Kühlvorrichtungsbreite 35 der Kühlvorrichtung 1.

Die Modulhöhe 29 bestimmt sich dabei durch den Deckflächenabstand 24 der ersten Deckfläche 4 von der zweiten Deckfläche 5. Die maximale Kühlelementlänge 23 der Kühlelemente 9 bestimmt sich durch einen Abstand der ersten Fläche 22 des Grundkörpers 8 von einem dem jeweiligen Kühlelement 9 zugeordneten Kühlelementabschluss 14, welcher jeweils von der ersten Fläche 22 des Grundkörpers 8 abgewandt ist.

Zu der Kühlvorrichtungsbreite 35 kann noch die erste Dicke 36 des Bauteilträgerelements 12, hier der Leiterplatte 13, hinzugezählt werden, um einen Vergleich mit der Gehäusebreite 30 des Umrichtergehäuses 26 herstellen zu können.

Ein Vergleich der Kühlvorrichtungsbreite 35 der erfindungsgemäßen Kühlvorrichtung 1 aus FIG 2 zur Kühlvorrichtungsbreite 135 der bekannten Kühlvorrichtung 101 aus FIG 1 zeigt auch augenscheinlich, dass die Kühlvorrichtungsbreite 35 der erfindungsgemäßen Kühlvorrichtung 1 aus FIG 2 deutlich gegenüber der Kühlvorrichtungsbreite 135 der bekannten Kühlvorrichtung 101 aus FIG 1 reduziert ist.

Somit kann die Gehäusebreite 30 des Umrichtergehäuses 26 des erfindungsgemäßen Umrichters 34, wie in FIG 2 gezeigt, deutlich gegenüber der Gehäusebreite 130 des Umrichtergehäuses 126 des bekannten Umrichters 134, wie in FIG 1 gezeigt, reduziert werden.

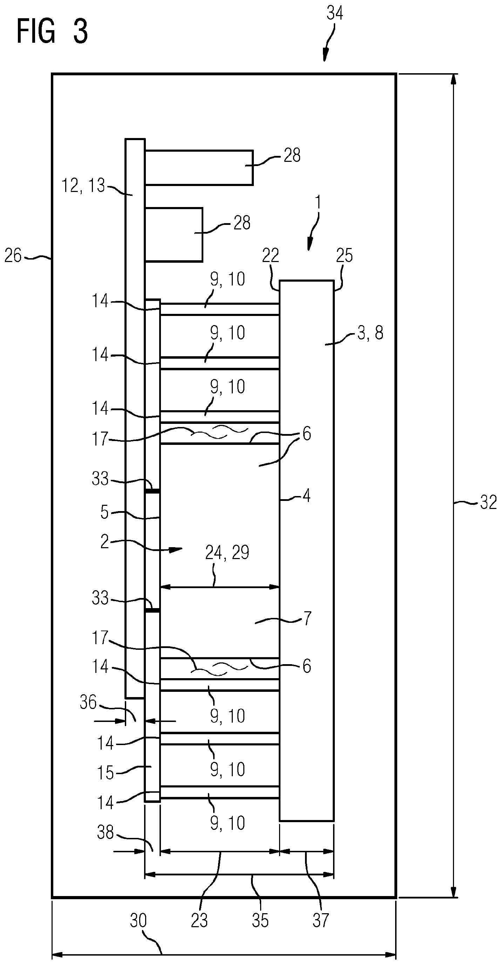

Mittels FIG 3 wird eine zweite schematische Schnittdarstellung der in das Umrichtergehäuse 26 des erfindungsgemäßen Umrichters 34 integrierten erfindungsgemäßen Kühlvorrichtung 1 nach FIG 2 aufgezeigt.

Die zweite schematische Schnittdarstellung aus FIG 3 entspricht im Wesentlichen der ersten schematischen Schnittdarstellung aus FIG 2, somit kann FIG 3 analog zu FIG 2 betrachtet werden, jedoch mit dem Unterschied, dass die Kühlvorrichtung 1 eine Kühlelementabdeckung 15 aufweist.

Diese Kühlelementabdeckung 15 ist mit den Kühlelementen 9, hier den Kühlrippen 10, über deren Kühlelementabschlüsse 14 verbunden. Die Kühlelementabdeckung 15 reicht in diesem Anwendungsbeispiel auch über das Halbleitermodul 2 und ist hier über die zweite Deckfläche 5 des Halbleitermoduls 2 mit dem Halbleitermodul 2 verbunden.

Im Gegensatz zu FIG 2 ist das Halbleitermodul 2 an seiner zweiten Deckfläche 5 nur über beispielhaft gezeigten zwei elektrischen Durchkontaktierungen 33 mit dem Bauteilträgerelement 12, hier der Leiterplatte 13, verbunden

Auch die Darstellung des Umrichtergehäuses 26 des Umrichters 34 in FIG 3 zeigt eine Sicht auf das Umrichtergehäuse 26, welche eine Gehäusebreite 30 und eine Gehäusehöhe 32 des Umrichtergehäuses 26 erkennen lässt.

Die Gehäusebreite 30 des Umrichtergehäuses 26 des Umrichters 24 wird, wie FIG 3 ebenfalls augenscheinlich zeigt, wesentlich durch eine Kühlvorrichtungsbreite 35 der Kühlvorrichtung 1 bestimmt.

Diese Kühlvorrichtungsbreite 35 summiert die Modulhöhe 29 des Halbleitermoduls 2, die zweiten Dicke 37 des Grundkörpers 8 des Kühlkörpers 3 und eine dritte Dicke 38 der Kühlelementabdeckung 15. Die Kühlelemente 9 sind hier bzgl. ihrer maximalen Kühlelementlänge 23 gleich groß wie die Modulhöhe 29 des Halbleitermoduls 2.

Die Modulhöhe 29 bestimmt sich dabei durch den Deckflächenabstand 24 der ersten Deckfläche 4 von der zweiten Deckfläche 5. Die maximale Kühlelementlänge 23 der Kühlelemente 9 bestimmt sich durch einen Abstand der ersten Fläche 22 des Grundkörpers 8 von einem dem jeweiligen Kühlelement 9 zugeordneten Kühlelementabschluss 14, welcher jeweils von der ersten Fläche 22 des Grundkörpers 8 abgewandt ist.

Zu der Kühlvorrichtungsbreite 35 kann noch die erste Dicke 36 des Bauteilträgerelements 12, hier der Leiterplatte 13, hinzugezählt werden, um einen Vergleich mit der Gehäusebreite 30 des Umrichtergehäuses 26 herstellen zu können.

Auch ein Vergleich der Kühlvorrichtungsbreite 35 der erfindungsgemäßen Kühlvorrichtung 1 aus FIG 3 zur Kühlvorrichtungsbreite 135 der bekannten Kühlvorrichtung 101 aus FIG 1 zeigt augenscheinlich, dass die Kühlvorrichtungsbreite 35 der erfindungsgemäßen Kühlvorrichtung 1 aus FIG 3 deutlich gegenüber der Kühlvorrichtungsbreite 135 der bekannten Kühlvorrichtung 101 aus FIG 1 reduziert ist.

Somit kann auch die Gehäusebreite 30 des Umrichtergehäuses 26 des erfindungsgemäßen Umrichters 34, wie in FIG 3 gezeigt, deutlich gegenüber der Gehäusebreite 130 des Umrichtergehäuses 126 des bekannten Umrichters 134, wie in FIG 1 gezeigt, reduziert werden.

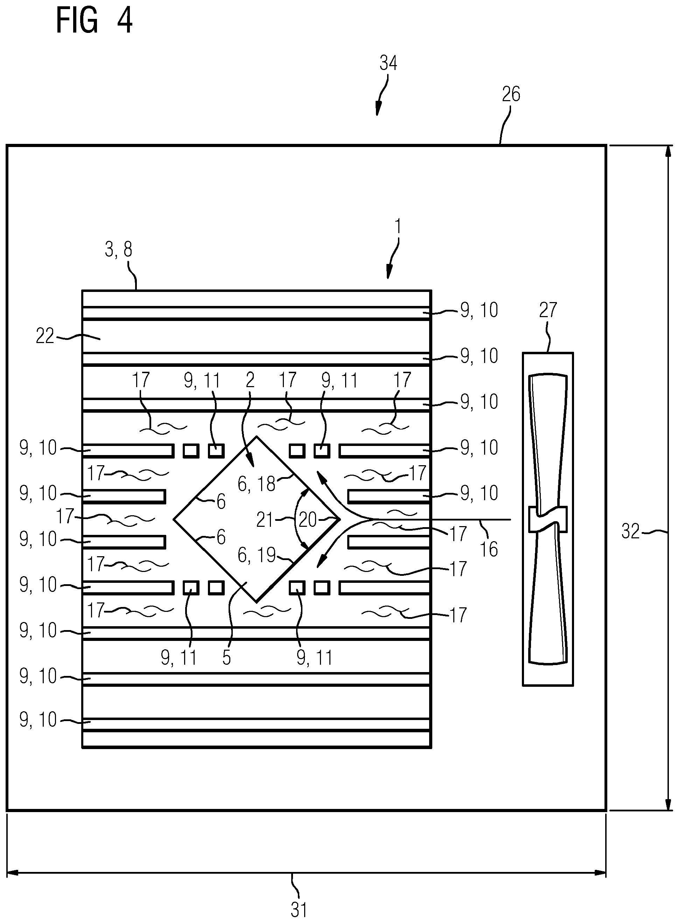

Die FIG 4 zeigt eine schematische Detaildarstellung der erfindungsgemäßen Kühlvorrichtung 1, integriert in das Umrichtergehäuse 26 des erfindungsgemäßen Umrichters 34 nach FIG 2 und FIG 3.

Die Kühlvorrichtung 1 ist hier in einer seitlichen Ansicht dargestellt. An der ersten Fläche 22 der Grundplatte 8 des Kühlkörpers 3 sind Kühlelemente 9 in einer Kombination aus Kühlrippen 10 und Pin Fins 11 ausgebildet. Das mit der ersten Fläche 22 der Grundplatte 8 verbundene Halbleitermodul 2 ist von den Kühlelementen 9 eingebettet.

Ein durch die Kühlelemente 9 in einer Strömungsrichtung 16 strömendes Kühlmedium 17 umströmt die Kühlelement 9 sowie das Halbleitermodul 2, insbesondere dessen Seitenflächen 6.

Eine erste Seitenfläche 18 der Seitenflächen 6 bildet mit der zweiten Seitenfläche 19 der Seitenflächen 6 eine gemeinsame Seitenkante 20 aus, welche der Strömungsrichtung 16 zugewandt ist, wobei die Zuwendung der ersten zur zweiten Seitenfläche 18,19 durch einen Kantenwinkel 21 bestimmt wird.

Dieser Kantenwinkel 21 beeinflusst die Strömungsrichtung 16 beim Vorbeiströmen des Kühlmediums 17 an der ersten und zweiten Seitenfläche 18,19 des Halbleitermoduls 2 und damit die entwärmende Wirkung des Kühlmediums 17 an der ersten und zweiten Seitenfläche 18,19 des Halbleitermoduls 2.

Ein Konvektionserzeuger 27, beispielsweise ein Ventilator für das Kühlmedien 17, welches gasförmige ist, oder eine Pumpe für das Kühlmedium 17, welches flüssig ist, erzeugt eine zwangsgeführte Konvektion des Kühlmediums 17 entlang der Strömungsrichtung 16.

Die schematische Detaildarstellung zeigt eine spezifische Sicht auf das Umrichtergehäuse 26 des Umrichters 34, welche eine Gehäusetiefe 31 und eine Gehäusehöhe 32 des Umrichtergehäuses 26 erkennen lässt.

## Patentansprüche

1. Kühlvorrichtung (1) mit einem Halbleitermodul (2) und einem Kühlkörper (3) zur Kühlung des Halbleitermoduls (2), wobei
- das Halbleitermodul (2) eine erste und zweite Deckfläche (4,5) und mehrere Seitenflächen (6) aufweist,
- die erste von der zweiten Deckfläche (4,5) abgewandt ist,
- zwischen den Deckflächen (4,5) ein Modulraum (7) des Halbleitermoduls (2) ausgebildet ist, welcher von den Seitenflächen (6) umschlossen ist,
- der Kühlkörper (3) einen Grundkörper (8) aufweist,
- an einer ersten Fläche (22) des Grundkörpers (8) von dem Grundkörper (8) abstehende Kühlelemente (9) ausgebildet sind,
- das Halbleitermodul (2) an der ersten Deckfläche (4) mit der ersten Fläche (22) des Grundkörpers (8) verbunden ist,
- das Halbleitermodul (2) zwischen zumindest einigen der Kühlelemente (9) eingebettet ist,
- die Kühlelemente (9) und die Seitenflächen (6) des Halbleitermoduls (2) in einer Strömungsrichtung (16) entlang des Grundkörpers (8) mittels eines Kühlmediums (17) umströmt werden können und die Kühlvorrichtung **dadurch gekennzeichnet ist dass**
- zumindest eine erste und eine zweite Seitenfläche (18,19) der Seitenflächen (6) des Halbleitermoduls (2) eine gemeinsame Seitenkante (20) ausbilden und die gemeinsame Seitenkante (20) der ersten und zweiten Seitenfläche (18,19) der Strömungsrichtung (16) zugewandt ist.

2. Kühlvorrichtung (1) nach Anspruch 1, wobei die Kühlelemente (9) als Kühlrippen (10) oder als Pin Fins (11) oder einer Kombination aus Kühlrippen (10) und Pin Fins (11) ausgebildet sind.

3. Kühlvorrichtung (1) nach einem der Ansprüche 1 oder 2, wobei das Halbleitermodul (2) an seiner zweiten Deckfläche (5) mit einem Bauteilträgerelement (12), insbesondere einer Leiterplatte (13), oder mit einer Kühlelementabdeckung (15) verbunden ist.

4. Kühlvorrichtung (1) nach Anspruch 3, wobei die Kühlelemente (9) jeweils einen von dem Grundkörper (8) abgewandten Kühlelementabschluss (14) ausbilden und zumindest einige der Kühlelemente (9) an deren Kühlelementabschluss (14) mit der Kühlelementabdeckung (15) verbunden sind.

5. Kühlvorrichtung (1) nach Anspruch 3 oder 4, wobei die Kühlelementabdeckung (15) aus einem gleichen metallischen Material ausgebildet ist, wie der Grundkörper (8) des Kühlkörper (3) und/oder die Kühlelemente (9).

6. Kühlvorrichtung (1) nach Anspruch 5, wobei der Kühlkörper (3) monolithisch aus dem Grundkörper (8), den Kühlelementen (9) und der Kühlelementabdeckung (15) ausgebildet ist.

7. Kühlvorrichtung (1) nach Anspruch 3 oder 4, wobei die Kühlelementabdeckung (15) als Bauteilträgerelement (12), insbesondere als Leiterplatte (13), ausgebildet ist.

8. Kühlvorrichtung (1) nach einem der vorhergehenden Ansprüche, wobei das Kühlmedium (17) flüssig, insbesondere Wasser, oder gasförmig, insbesondere Luft, ist.

9. Kühlvorrichtung (1) nach einem der vorhergehenden Ansprüche , wobei ein Kantenwinkel (21) an der gemeinsamen Seitenkante (20) zwischen der ersten und zweiten Seitenfläche (18,19) einen Winkelwert in einem Winkelbereich von 30° bis 60°, insbesondere von 45°, aufweist.

10. Kühlvorrichtung (1) nach einem der vorhergehenden Ansprüche, wobei eine maximale Kühlelementlänge (23) der an der ersten Fläche (22) des Grundkörpers (8) ausgebildeten Kühlelemente (9), beginnend von der ersten Fläche (22) des Grundkörpers (8) bis zum Kühlelementabschluss (14) des jeweiligen Kühlelements (9), durch einen Deckflächenabstand (24), welcher eine Modulhöhe (29) des Halbleitermoduls (2) bestimmt, zwischen der ersten Deckfläche (4) und der zweiten Deckfläche (5) des Halbleitermoduls (2) begrenzt wird.

11. Kühlvorrichtung (1) nach einem der vorhergehenden Ansprüche, wobei eine von der ersten Fläche (22) des Grundkörpers (8) abgewandte zweite Fläche (25) des Grundkörpers (8) frei von Kühlelementen ist.

12. Umrichter (34) mit einer Kühlvorrichtung (1) nach einem der Ansprüche 1 bis 11 und einem Umrichtergehäuse (26), wobei die Kühlvorrichtung (1) in das Umrichtergehäuse (26) integriert ist.

13. Umrichter (34) nach Anspruch 12, wobei durch einen Konvektionserzeuger (27) eine erzwungene Konvektion des Kühlmediums (17) erzeugbar ist.

## Claims

1. Cooling apparatus (1) having a semiconductor module (2) and a heat sink (3) for cooling the semiconductor module (2), wherein
- the semiconductor module (2) has a first and second cover face (4,5) and a plurality of side faces (6),
- the first cover face (4) faces away from the second cover face (5),
- a module space (7) of the semiconductor module (2) is formed between the cover faces (4,5), said module space being enclosed by the side faces (6),
- the heat sink (3) has a base body (8),
- cooling elements (9) are formed on a first face (22) of the base body (8) and said cooling elements project from the base body (8),
- the semiconductor module (2) is connected to the first face (22) of the base body (8) at the first cover face (4),
- the semiconductor module (2) is embedded between at least some of the cooling elements (9),
- a cooling medium (17) can flow around the cooling elements (9) and the side faces (6) of the semiconductor module (2) in a flow direction (16) along the base body (8) and the cooling apparatus is **characterised in that**
- at least a first and a second side face (18, 19) of the side faces (6) of the semiconductor module (2) form a common side edge (20) and the common side edge (20) of the first and second side face (18,19) faces the flow direction (16).

2. Cooling apparatus (1) according to claim 1, wherein the cooling elements (9) are formed as cooling fins (10) or as pin fins (11) or a combination of cooling fins (10) and pin fins (11) .

3. Cooling apparatus (1) according to one of claims 1 or 2, wherein the semiconductor module (2) is connected at its second cover face (5) to a component support element (12), in particular a printed circuit board (13), or to a cooling element cover (15).

4. Cooling apparatus (1) according to claim 3, wherein the cooling elements (9) each form a cooling element end (14) that faces away from the base body (8) and at least some of the cooling elements (9) are connected at their cooling element end (14) to the cooling element cover (15).

5. Cooling apparatus (1) according to claim 3 or 4, wherein the cooling element cover (15) is made of the same metal material as the base body (8) of the heat sink (3) and/or the cooling elements (9).

6. Cooling apparatus (1) according to claim 5, wherein the heat sink (3) is monolithically formed from the base body (8), the cooling elements (9) and the cooling element cover (15).

7. Cooling apparatus (1) according to claim 3 or 4, wherein the cooling element cover (15) is formed as a component support element (12), in particular as a printed circuit board (13) .

8. Cooling apparatus (1) according to one of the preceding claims, wherein the cooling medium (17) is liquid, in particular water, or gaseous, in particular air.

9. Cooling apparatus (1) according to one of the preceding claims, wherein an edge angle (21) at the common side edge (20) between the first and second side face (18,19) has an angle value in an angular range of 30° to 60°, in particular 45°.

10. Cooling apparatus (1) according to one of the preceding claims, wherein a maximum cooling element length (23) of the cooling elements (9) that are formed on the first face (22) of the base body (8), starting from the first face (22) of the base body (8) to the cooling element end (14) of the respective cooling element (9), is limited by a cover face distance (24), which determines a module height (29) of the semiconductor module (2), between the first cover face (4) and the second cover face (5) of the semiconductor module (2).

11. Cooling apparatus (1) according to one of the preceding claims, wherein cooling elements are not formed on a second face (25) of the base body (8), said second face facing away from the first face (22) of the base body (8).

12. Converter (34) having a cooling apparatus (1), according to one of claims 1 to 11, and a converter housing (26), wherein the cooling apparatus (1) is integrated in the converter housing (26).

13. Converter (34) according to claim 12, wherein forced convection of the cooling medium (17) can be generated by a convection generator (27).

## Revendications

1. Dispositif (1) de refroidissement comprenant un module (2) à semiconducteur et un puits (3) de chaleur pour le refroidissement du module (2) à semiconducteur,
dans lequel
- le module (2) à semiconducteur a une première et une deuxième surface (4, 5) de recouvrement et plusieurs surfaces (6) latérales,
- la première n'est pas tournée vers la deuxième surface (4, 5) de recouvrement,
- entre les surfaces (4, 5) de recouvrement, est constitué un espace (7) de module du module (2) à semiconducteur, qui est entouré par les surfaces (6) latérales,
- le puits (3) de chaleur a un corps (8) de base,
- sur une première surface (22) du corps (8) de base, sont constitués des éléments (9) de refroidissement en saillie du corps (8) de base,
- le module (2) à semiconducteur est relié à la première surface (4) de recouvrement par la première surface (22) du corps (8) de base,
- le module (2) à semiconducteur est inséré entre au moins certains des éléments (9) de refroidissement,
- autour des éléments (9) de refroidissement et des surfaces (6) latérales du module (2) à semiconducteur peut s'écouler, dans un sens (16) d'écoulement le long du corps (8) de base, au moins un fluide (17) de refroidissement et le dispositif de refroidissement est **caractérisé en ce que**
- au moins une première et une deuxième surfaces (18, 19) latérales, parmi les surfaces (6) latérales du module (2) à semiconducteur, forment une arête (20) latérale commune et l'arête (20) latérale commune à la première et à la deuxième surfaces (18, 19) latérales est tournée vers le sens (16) d'écoulement.

2. Dispositif (1) de refroidissement suivant la revendication 1, dans lequel les éléments (9) de refroidissement sont constitués sous la forme d'ailettes (10) de refroidissement ou de pin fins (11) ou d'une combinaison d'ailettes (10) de refroidissement et de pin fins (11).

3. Dispositif (1) de refroidissement suivant l'une des revendications 1 ou 2, dans lequel le module (2) à semiconducteur est, sur sa deuxième surface (5) de recouvrement, relié à un élément (12) porteur de composant, en particulier à une plaquette (13) à circuit imprimé, ou à un recouvrement (15) d'élément de refroidissement.

4. Dispositif (1) de refroidissement suivant la revendication 3, dans lequel les éléments (9) de refroidissement forment respectivement une terminaison (14) d'élément de refroidissement, non tournée vers le corps (8) de base et au moins certains des éléments (9) de refroidissement sont, sur leur terminaison (14) d'élément de refroidissement, reliés au recouvrement (15) d'élément de refroidissement.

5. Dispositif (1) de refroidissement suivant la revendication 3 ou 4, dans lequel le recouvrement (15) de l'élément de refroidissement est en un même matériau métallique que le corps (8) de base du puits (3) de chaleur et/ou que les éléments (9) de refroidissement.

6. Dispositif (1) de refroidissement suivant la revendication 5, dans lequel le puits (3) de chaleur est constitué monolithiquement du corps (8) de base, des éléments (9) de refroidissement et de recouvrements (15) d'élément de refroidissement.

7. Dispositif (1) de refroidissement suivant la revendication 3 ou 4, dans lequel le recouvrement (15) d'élément de refroidissement est constitué sous la forme d'un élément (12) de support de composant, en particulier sous la forme d'une plaquette (13) à circuit imprimé.

8. Dispositif (1) de refroidissement suivant l'une des revendications précédentes, dans lequel le fluide (17) de refroidissement est liquide, en étant en particulier de l'eau, ou gazeux, en étant en particulier de l'air.

9. Dispositif (1) de refroidissement suivant l'une des revendications précédentes, dans lequel un angle (21) d'arête, à l'arête (20) latérale commune entre la première et la deuxième surfaces (18, 19) latérales, a une valeur dans une plage angulaire de 30° à 60°, en ayant en particulier une valeur de 45°.

10. Dispositif (1) de refroidissement suivant l'une des revendications précédentes, dans lequel une longueur (23) maximum des éléments (9) de refroidissement, constitués sur la première surface (22) du corps (8) de base, en commençant de la première surface (22) du corps (8) de base en allant jusqu'à la terminaison (14) de l'élément de refroidissement (9) respectif, est délimitée par une distance (24) de surface de recouvrement, qui détermine une hauteur (29) du module (2) à semiconducteur, entre la première surface (4) de recouvrement et la deuxième surface (5) de recouvrement du module (2) à semiconducteur.

11. Dispositif (1) de refroidissement suivant l'une des revendications précédentes, dans lequel une deuxième surface (25) du corps (8) de base, non tournée vers la première surface (22) du corps (8) de base, est sans élément de refroidissement.

12. Onduleur (34) ayant un dispositif (1) de refroidissement suivant l'une des revendications 1 à 11 et un boîtier (26) d'onduleur, dans lequel le dispositif (1) de refroidissement est intégré dans le boîtier (26) de l'onduleur.

13. Onduleur (34) suivant la revendication 12, dans lequel une convection forcée du fluide (17) de refroidissement peut être produite par un dispositif (27) de production d'une convection.
